(19) Europäisches Patentamt
European Patent Office
Office européen des brevets

(11) **EP 3 069 448 B1**

(12) **EUROPÄISCHE PATENTSCHRIFT**

(45) Veröffentlichungstag und Bekanntmachung des Hinweises auf die Patenterteilung:
**06.03.2019 Patentblatt 2019/10**

(21) Anmeldenummer: **14799148.3**

(22) Anmeldetag: **14.11.2014**

(51) Int Cl.:
*H03M 3/02* (2006.01)  *H03M 7/34* (2006.01)
*H03M 1/12* (2006.01)  *H03M 1/50* (2006.01)
*H03M 1/82* (2006.01)  *H03M 3/00* (2006.01)

(86) Internationale Anmeldenummer:
**PCT/EP2014/074628**

(87) Internationale Veröffentlichungsnummer:
**WO 2015/071421 (21.05.2015 Gazette 2015/20)**

(54) **ELEKTRISCHE SCHALTUNG ZUR SIGNALVERARBEITUNG**

ELECTRIC SIGNAL PROCESSING CIRCUIT

CIRCUIT ÉLECTRIQUE DE TRAITEMENT DE SIGNAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.11.2013 DE 102013223394**

(43) Veröffentlichungstag der Anmeldung:
**21.09.2016 Patentblatt 2016/38**

(73) Patentinhaber: **Fraunhofer-Gesellschaft zur Förderung der angewandten Forschung e.V.
80686 München (DE)**

(72) Erfinder:
• **HACKNER, Michael
93155 Hemau OT Haag (DE)**

• **HOHE, Hans-Peter
91332 Heiligenstadt (DE)**
• **SAND, Markus
92723 Tännesberg (DE)**

(74) Vertreter: **Schenk, Markus et al
Schoppe, Zimmermann, Stöckeler
Zinkler, Schenk & Partner mbB
Patentanwälte
Radlkoferstrasse 2
81373 München (DE)**

(56) Entgegenhaltungen:
**DE-A1-102012 003 909  US-A1- 2007 247 340**

**Beschreibung**

Ausführungsbeispiele der vorliegenden Erfindung beziehen sich auf eine elektrische Schaltung zur Signalverarbeitung und auf ein Verfahren zur Signalverarbeitung.

Unter einer Signalverarbeitung kann beispielsweise eine Analog-Digital-Wandlung oder eine Digital-Analog-Wandlung, aber auch eine Digital-Digital-Wandlung verstanden werden. Eine häufig bei Analog-Digital- bzw. Digital-Analog-Wandlern eingesetzte Schaltungstechnologie basiert auf der sogenannten Delta-Sigma-Modulation (DSM). Um störende Effekte, wie zyklische Wiederholungen des Ausgangspatterns, bei Sigma-Delta-Wandlern zu vermeiden, werden diese beispielsweise mit Reset zwischen den Messwerten (d.h. inkrementell) betrieben. Ferner kann es bei der FFT (Fast Fourier Transformation) zu sogenannten Leakage-Effekten kommen, wenn ein Signal von der FFT als periodisch betrachtet wird, aber im betrachteten Zeitfenster keine ganze Zahl von Perioden des Signals enthalten sind.

Um diese Effekte zu vermeiden, gibt es unterschiedliche Ansätze. Entsprechend einem ersten Ansatz kommt eine zeitliche Gewichtung von Fensterfunktionen zur Anwendung, die aber die Nebenlinien tendenziell nur dämpft, nicht aber (systematisch) vermeiden. Ein weiterer Ansatz basiert auf der Synchronisierung von Systemfrequenzen relativ zu einer Referenz-Frequenz, beispielsweise unter Nutzung eines Phasenregelkreises (PLL, phase locked loop). Ein Anwendungsbeispiel ist die Messtechnik; In der Messtechnik werden PLLs beispielsweise eingesetzt, um die Sampling-Rate (Rate der Messwertaufnahmen) an eine definierte Periode eines zu messenden periodischen Signals anzupassen. Im Detail wird die System- bzw. Abtastfrequenz eines gesteuerten Oszillators unter Zuhilfenahme der Phasenregelschleife, an das zu messende Signal so angepasst, dass eine Synchronisierung von Sampling-Rate zu Referenz-Frequenz mittels des PLLs erfolgt.

Die Patentanmeldung DE 2012 003909 befasst sich mit Sigma-Delta-Analog-Digital-Wandlern, bei denen ein Integrator über eine vorher festgelegte Anzahl von Dezimationsabtastwerten aufsummiert. Nach einem Triggern durch einen Integrationszähler 105, wird der Integrationswert, der durch Integration über die vorher festgelegte Anzahl von Dezimationsabtastwerten erhalten worden ist, zu dem Integratorausgang 106 übertragen, der Integrator wird zurückgesetzt und die Integration startet abermals von neuem.

Nachfolgend wird dieser Mechanismus zusammen mit den resultierenden Nachteilen anhand eines Beispiels erläutert. In einem Wechselspannungs-Drehstromsystem sollen die elektrischen Größen Strom und Spannung gemessen werden. Die Messung soll mit einer üblichen Sampling-Rate bzw. Messrate von $2^6 = 64$ Messwerten pro Periode erfolgen, da Messraten in dieser Größenordnung auch einen sehr effizienten Fast-Fourier-Transformations-Algorithmus (FFT-Algorithmus) ermöglichen. Es sei angenommen, dass der Systemtakt des Messaufbaus in einem Bereich von ca. 8 MHz liegt, um die für die Analog-Digital-Wandlung eingesetzte Sigma-Delta-Modulation optimal betreiben zu können. Realisierungstechnisch kann hier eine PLL verwendet werden, der jeden 64. Abtastwert als Repräsentation des Phasenfehlers nimmt. Eilt beispielsweise die Phase des gesteuerten Oszillators nach, weil z. B. die Ausgangs-Frequenz zu niedrig ist, ergibt sich ein Abtastwert > 0. Im umgekehrten Fall, wenn die Phase voreilt, ist der Abtastwert < 0. Diese Abweichungen vom Sollwert "0" können über die Ermittlung des Phasenfehlers detektiert werden, sodass eine entsprechende Korrektur möglich ist. Nachteilig hieran ist jedoch, dass sich insbesondere bei Anwendungen an Versorgungsnetzen mit geringen Frequenzen (50 Hz, 60 Hz oder 16 2/3 Hz) ein hoher Teilungsfaktor zwischen Systemtakt (8 MHz) und Referenztakt (50 Hz, 60 Hz bzw. 16 2/3 Hz) einstellt. Dieser liegt je nach Anwendung im Bereich von $1,3 \times 10^5$ (8 MHz / 60 Hz) und $4,8 \times 10^5$ (8 MHz / 16,7 Hz). Infolgedessen kann die Regelung sehr träge werden, wobei andererseits durch den steuerbaren Oszillator eine umso feiner aufgelöste Frequenzeinstellung ermöglicht werden muss, die die Reglerabweichung von einem Phasenvergleich zu einem nächsten nicht zu groß werden lässt. Derartige fein einstellbare Oszillatoren haben allerdings einen hohen Flächen- und Strombedarf. Deshalb besteht der Bedarf nach einem verbesserten Ansatz.

Die US 2007/247340 A1 beschreibt einen Sigma-Delta-Modulator mit einem AD-Wandler.
Aufgabe der vorliegenden Erfindung ist es, ein Konzept zur effizienten Nachregelung einer Signalverarbeitungskette ohne steuerbaren Oszillator zu schaffen.
Die Aufgabe wird durch die unabhängigen Patentansprüche gelöst.
Ausführungsbeispiele der vorliegenden Erfindung schaffen eine elektrische Schaltung mit einer Signalverarbeitungskette und einer Steuerung. Die Signalverarbeitungskette, z.B. die Signalverarbeitungskette eines Analog-Digital-Wandlers, umfasst zumindest einen Integrator (analog oder digital), der ausgebildet ist, um ein Eingangssignal über eine Integrationszeit hinweg zu integrieren. Das (integrierte) Ausgangssignal der Signalverarbeitungskette wird über die Steuerung, die mit dem Signalausgang der Signalverarbeitungskette verbunden ist, empfangen und (z. B. hinsichtlich Phasenfehlern) ausgewertet. Die Steuerung ist ferner ausgebildet, um die Integrationszeit basierend auf dem Ausgangssignal (bzw. der Auswertung des Ausgangssignals) anzupassen, um unter Berücksichtigung des oben erläuterten Teilungsfaktors eine gute Synchronisation zwischen der Integrationszeit und einer Grundwelle des Eingangssignals erreichen zu können (z.B. ein Synchronlauf mit max. 3% oder 1% oder sogar 0,1% Abweichung).

Kern der vorliegenden Erfindung liegt somit darin, dass entsprechend dem neuen Konzept nicht mehr die Systemfrequenz (Oversamplingfrequenz) über einen steuerbaren Oszillator und eine Regelung der Phase (PLL) der Grundfrequenz des Eingangssignals nachgeführt wird, sondern dass stattdessen die Anzahl der Systemtakte, die in ein Messintervall (ein Messintervall je Messwert) eingehen, (und damit die effektive Dauer des Messintervalls) angepasst wird. Die Anpassung der effektiven Dauer des Messintervalls an die Grundfrequenz des Eingangssignals erfolgt dadurch, dass die Integrationszeit des Integrators, der Teil der Signalverarbeitungskette ist, variiert wird. Dies bietet den wesentlichen Vorteil, dass die Systemtakt-Frequenz stabil bleiben kann. Eine konstante Systemtakt-Frequenz wirkt sich insbesondere auf digitale Signal-Verarbeitungs-Blöcke, die über den Systemtakt betrieben werden, positiv aus, sodass diese mit geringen Anforderungen, z.B. an die Setup-Zeiten, entworfen werden können, weil Toleranzen der Signalfrequenz nicht berücksichtigt werden müssen. Als Konsequenz wird auch der steuerbare Oszillator nicht mehr benötigt, sodass die Schaltung mit sehr geringer (Chip-) Fläche und damit auch mit geringen Herstellungskosten realisierbar ist. Des Weiteren sind auch positive Effekte hinsichtlich Stromverbrauch und Temperatur bzw. Prozessabhängigkeit festzustellen.

Entsprechend einem bevorzugten Ausführungsbeispiel umfasst die Signalverarbeitungskette einen Sigma-Delta-Modulator, der zumindest der Ordnung 1 entspricht. Der Sigma-Delta-Modulator kann ausgebildet sein, um auf Basis eines analogen Eingangssignals ein digitales Ausgangssignal bereitzustellen. Dadurch, dass nur noch die Integrationsdauer des Integrators des Sigma-Delta-Modulators variiert wird und der Systemtakt konstant bleibt, kann der Sigma-Delta-Modulator immer im optimalen Arbeitspunkt seiner Taktfrequenz betrieben werden. Infolge dessen ist eine Auslegung für größere Frequenz-Unterschiede nicht mehr notwendig.

Entsprechend Ausführungsbeispielen kann die Signalverarbeitungskette ausgangsseitig einen Filter oder auch einen Dezimationsfilter umfassen, wobei angemerkt sei, dass entsprechend einem weiteren Ausführungsbeispiel der Dezimationsfilter den Integrator der Signalverarbeitungskette aufweisen kann.

Ferner kann bei einer derartigen digitalen Ausgangsstufe auch ein Divisionsbildungselement ausgangsseitig vorgesehen sein, das ausgebildet ist, um das Ausgangssignal der Signalverarbeitungskette durch die Integrationszeit zu dividieren, um den Divisionswert als Ergebnis auszugeben. Dies bietet den Vorteil, dass Skalierungseffekte infolge der Variation der Integrationszeit direkt kompensiert werden können.

Entsprechend weiteren Ausführungsbeispielen kann ausgangsseitig ein Phasen-Diskriminator (z.B. ein Abtast-Halte-Glied als Phasen-Diskriminator) vorgesehen sein, der ausgebildet ist, das Ausgangssignal hinsichtlich Phasenfehlern auszuwerten und auf Basis der Auswertung die Integrationszeit anzupassen, um den Phasenfehler zu reduzieren bzw. zu minimieren. Entsprechend weiteren Ausführungsbeispielen erfolgt die Steuerung der Integrationszeit derart, dass die Periode der Grundwelle des Eingangssignals ein ganzzahliges Vielfaches der mittleren Integrationszeit ist. Hintergrund hierzu ist, dass für eine sehr feine Einstellung der Periode die Messdauer zwischendurch minimal variiert wird, so dass die Periode des Signals nicht nur zwischen dem N- und N+1- oder N-1-fachen der Integrationszeit für einen Messwert liegt, sondern noch deutlich feiner aufgelöst werden kann.

Ausführungsbeispiele schaffen ein Verfahren zur Signalverarbeitung. Das Verfahren umfasst zumindest die Schritte "Integrieren eines Eingangssignals über eine Integrationszeit" hinweg mittels einer Signalverarbeitungskette, die einen Integrator umfasst, "Empfangen und Auswerten eines Ausgangssignals" der Signalverarbeitungskette sowie "Anpassen der Integrationszeit" basierend auf dem Ausgangssignal.

Ausführungsbeispiele der vorliegenden Erfindung werden nachfolgend anhand der beiliegenden Zeichnungen erläutert. Es zeigen:

Fig. 1a ein schematisches Blockschaltbild einer elektrischen Schaltung mit einer Signalverarbeitungseinrichtung und einer Steuerung gemäß einem ersten Ausführungsbeispiel;

Fig. 1b ein schematisches Flussdiagramm des Verfahrens zum Betreiben der in Fig. 1a gezeigten Signalverarbeitungseinrichtung;

Fig. 2 ein schematisches Blockschaltbild einer elektrischen Schaltung mit einem Analog-Digital-Umsatz und einer Steuerung gemäß einem weiteren Ausführungsbeispiel; und

Fig. 3 ein schematisches Blockschaltbild einer elektrischen Schaltung mit einem Dezimationsfilter und einer Steuerung gemäß einem weiteren Ausführungsbeispiel.

Bevor nachfolgend Ausführungsbeispiele der vorliegenden Erfindung anhand der beiliegenden Figuren im Detail erläutert werden, wird darauf hingewiesen, dass gleichwirkende Elemente oder Strukturen mit gleichen Bezugszeichen versehen sind, sodass die Beschreibung derer aufeinander anwendbar bzw. austauschbar ist.

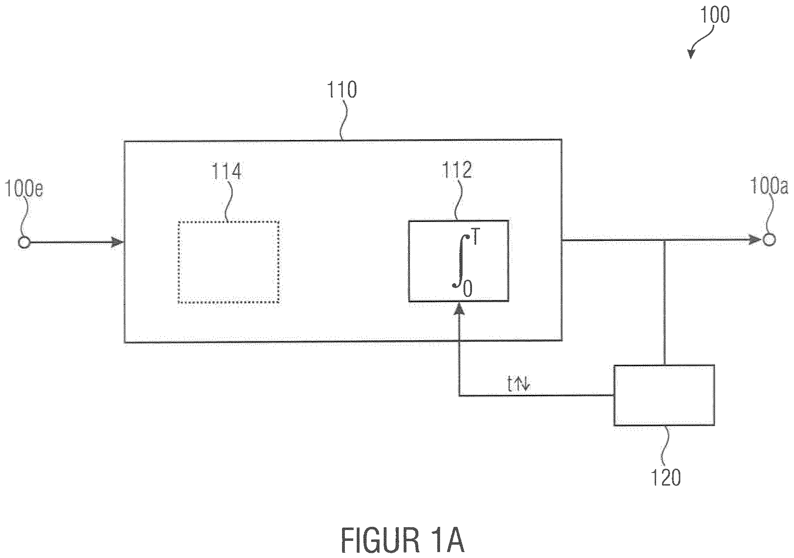

Fig. 1a zeigt eine elektrische Schaltung 100 mit einer integrierenden Signalverarbeitungskette 110 und einer Steuerung 120. Die Signalverarbeitungskette 110 umfasst also zumindest einen Integrator 112, der direkt oder über ein optionales Schaltungselement 114, wie z. B. einen Komparator eines Sigma-Delta-Wandlers, mit einem Eingang 100e der Signalverarbeitungskette 110 verbunden ist. Der Integrator 112 kann alternativ auch Teil eines Schaltungselements der Signalverarbeitungskette 110, wie zum Beispiel Teil eines (digitalen) Filters bzw. Dezimationsfilters, sein. Die Steuerung 120 der elektrischen Schaltung 100 ist derart angeordnet, dass diese ein von dem Ausgang der Signalverarbeitungskette 110 ausgesendetes Signal empfängt, und ist mittels eines Steuerkanals mit dem Integrator 112 gekoppelt. Nachdem die Schaltungstopologie der Schaltung 100 erläutert ist, wird nachfolgend auf die Funktionsweise derselben eingegangen.

Für die folgende Erläuterung wird davon ausgegangen, dass es sich bei der Signalverarbeitungskette 110 um eine Signalverarbeitungskette handelt, die ausgebildet ist, um eine Analog-Digital-Transformation durchzuführen, wobei jedoch angemerkt sei, dass auch anders geartete Signalverarbeitungsketten mit einem Integrator 112 denkbar sind. Bei der vorliegenden Signalverarbeitungskette 110 wird über den Eingang 100e ein elektrisches Eingangssignal oder, um genau zu sein, ein analoges Signal, wie z. B. ein Sinussignal, mit einer Grundwelle von z.B. 16 2/3 Hz empfangen. Die Grundwelle ist durch die Periode bestimmt und kann beispielsweise zwischen 5 Hz und 50 kHz betragen. Dieses Signal wird nun den Schaltungsbestandteilen der Signalverarbeitungskette 110, wie z. B. dem Komparator 114, zugeführt, der das Signal mit einem Schwellwert vergleicht und mit 1 oder 0 bewertet. Dieses binäre Signal wird nun durch den Integrator 112 über eine vorbestimmte Integrationszeit T aufintegriert. Diese Integrationszeit T legt abhängig von dem Systemtakt die effektive Messdauer fest. Wie oben bereits angemerkt kann der Integrator 112 auch Teil des optionalen Dezimationsfilters (z.B. Dezimationsfilter 1. Ordnung) sein. Mittels des digitalen Dezimationsfilters ist es nun möglich, ein niedrig aufgelöstes Signal, z. B. ein 1-Bit-Digitalsignal mit hoher Datenrate (z. B. 0,4 MHz), derart zu konvertieren, dass dieses eine höhere Auflösung (z. B. 4 Bit, 16 Bit oder 24 Bit) bei einer niedrigeren Erneuerungsrate (z. B. 96 kHz oder 48 kHz) hat. Die resultierende Summe der Ausgangssignale im Dezimationsfilter repräsentiert den Messwert des Signals im Messintervall. Das so konvertierte digitale Signal (z. B. 4-Bit-Ausgangs-Wort) kann nun über den Ausgang 100a ausgegeben werden. Wie oben bereits erläutert, ist im Hinblick auf Effekte, wie das Auftreten spektraler Nebenlinien, ein synchroner Lauf zwischen der Grundfrequenz des Messsignals (vergleiche Eingang 100e) und der Oversamplingfrequenz des Delta-Sigma-Wandlers 110, die von der Systemfrequenz abhängig ist, vorteilhaft. Entsprechend dem Stand der Technik-Ansatz erfolgt hierzu eine Nachregelung der Systemfrequenz über einen steuerbaren Oszillator unter Zuhilfenahme eines PLLs.

Entsprechend dem Erfindungsgedanken wurde allerdings erkannt, dass es auch möglich ist, das Messintervall T so anzupassen, dass ein ganzzahliges Vielfaches, hier z. B. das 64-fache, der Dauer der Messintervalle exakt in eine Grundwelle des zu messenden Signals passt. Hierzu wird die effektive Dauer des Messintervalls über die Festlegung der Integrationszeit T des Integrators 112 in dem Delta-Sigma-Modulator 110 und damit die Anzahl der Systemtakte je Messintervall (die in die Messung eingehen) an die Periodendauer der Grundwelle des Messsignals angepasst. Die Anpassung erfolgt unter Zuhilfenahme der Steuerung 120, die das von der Signalverarbeitungskette 110 ausgegebene Signal analysiert und auf Basis des Analyseergebnisses über den Steuerkanal ein Steuersignal, abgeleitet aus dem Ausgangssignal (vergleiche Ausgang 100a), zur Steuerung der Integrationsdauer T ausgibt. Somit können die oben angesprochenen Effekte durch die Synchronisation von Integrationsdauer T an die Grundfrequenz des Messsignals (vergleiche Eingang 100e) vermieden werden, ohne dass eine Anpassung der Systemtaktfrequenz notwendig ist. Insofern wird die gesamte Regelstruktur, die ohne steuerbaren Oszillator auskommt und auf einem konstanten Systemtakt basiert, vereinfacht. Insbesondere sehr hoch aufgelösten Messungen können ohne Zusatzaufwand für einen steuerbaren Oszillator realisiert werden. Dies wirkt sich positiv auf die Systemkomplexität aus und führt so zu einer Minimierung der Schaltungsgröße.

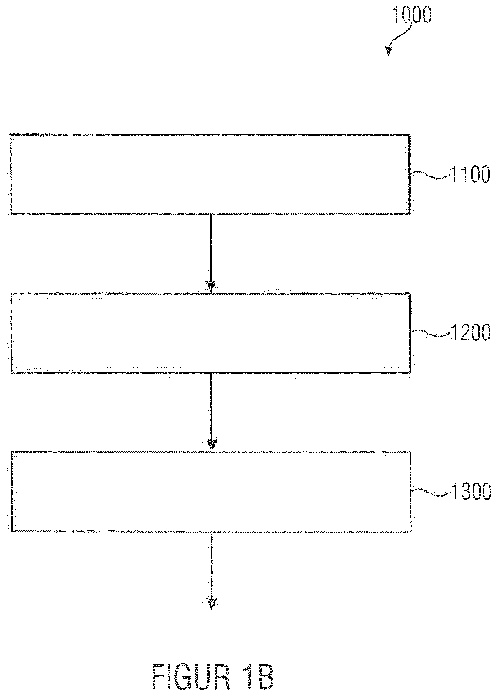

Wie oben bereits angedeutet, ist das beschriebene Prinzip nicht nur auf Sigma-Delta-Wandler anwendbar, sondern auch auf weitere elektrische Schaltungen übertragbar, die Synchronisation der Schaltung an das zu verarbeitende Signal nicht mehr durch Variation des Systemtakts realisieren, sondern dadurch, dass die Integrationszeit T des Integrators von extern bzw. mittels einer Steuerung beeinflusst wird. Das zugehörige Verfahren wird nachfolgend Bezug nehmend auf Fig. 1b erläutert.

Fig. 1b zeigt ein Flussdiagramm 1000 mit den drei Basisschritten 1100, 1200 und 1300. Der erste Basisschritt 1100 umfasst das Integrieren des Eingangssignals über die Integrationszeit T hinweg mittels eines in der Signalverarbeitungskette 110 beinhalteten Integrators 112. In einem nächsten Schritt 1200 wird das von der Signalverarbeitungskette 110 ausgegebene Signal durch die Steuerung empfangen, so dass abhängig von diesem die Integrationszeit T angepasst werden kann (vgl. Schritt 1300). Die Anpassung der Integrationszeit T kann z. B. anhand eines in dem Schritt 1200 ermittelten Phasenfehlers $\delta\varphi$ erfolgen. Diese wird an die Grundwelle des Eingangssignals (vergleiche 100e der Signalverarbeitungskette 110) angepasst. Entsprechend Ausführungsbeispielen erfolgt dies so, dass die Periode der Grundwelle des Eingangssignals ein ganzzahliges Vielfaches der Integrationszeit T ist.

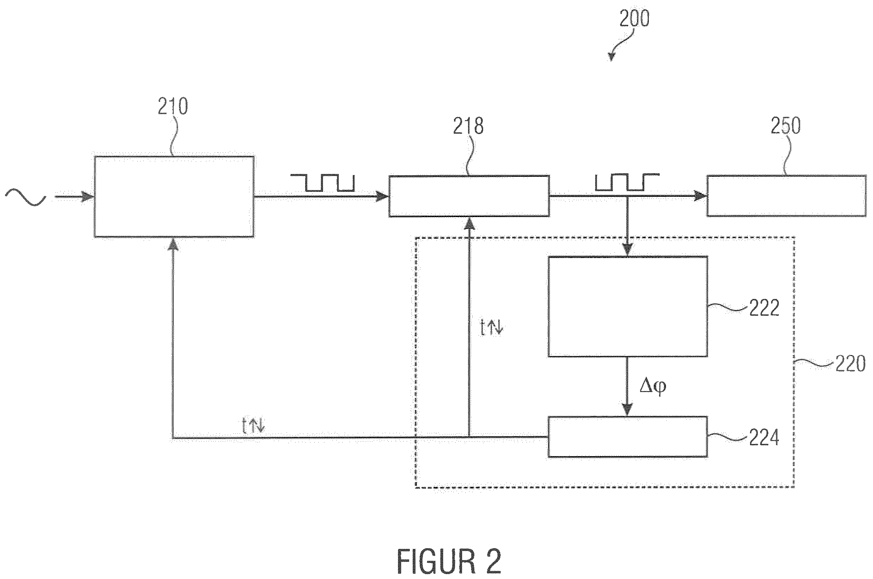

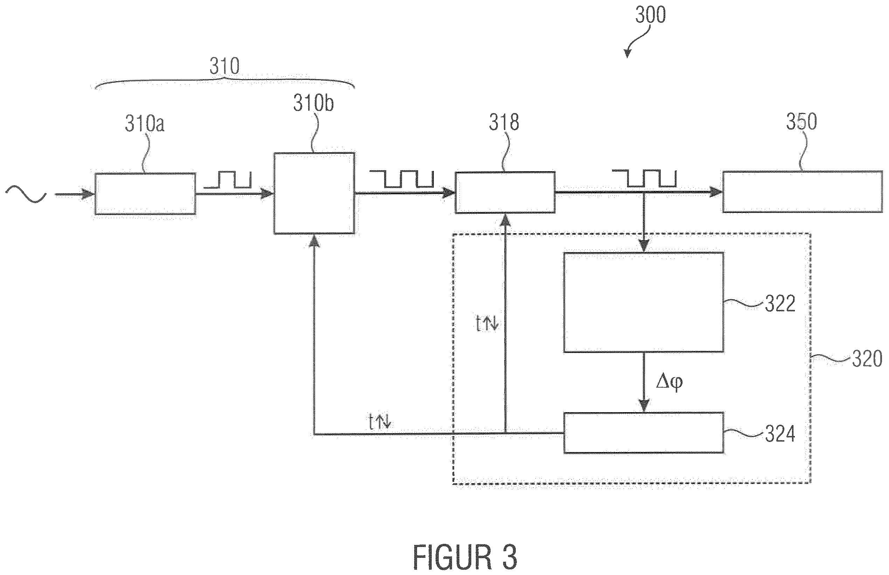

Bezug nehmend auf Fig. 2 und 3 werden nun weitere konkrete Ausführungsbeispiele insbesondere mit Fokus auf die Steuerung erläutert.

Fig. 2 zeigt eine elektrische Schaltung 200 mit einem Analog-Digital-Umsetzer 210, der ebenfalls einen Integrator (nicht dargestellt) umfasst und deshalb im Folgenden als integrierender Analog-Digital-Umsetzer (I-ADU) 210 bezeichnet wird. Der integrierende Analog-Digital-Umsetzer 210 ist eingangsseitig mit einer analogen Signalquelle (nicht dargestellt) verbunden und ausgangsseitig mit einer digitalen Nachverarbeitungsstufe 218 und einem weiteren Signalverarbeitung 250. Die Nachverarbeitungsstufe 218 kann beispielsweise ein Divisionsbildungselement umfassen und ist ferner ausgangsseitig einerseits mit der Signalverarbeitung 250 und mit der Steuerung 220 verbunden.

Die Steuerung 220 umfasst in diesem Ausführungsbeispiel einen Signalanalysator 222, wie z. B. einen Phasen-Diskriminator, und ein Integrationszeitregler 224 zur Regelung der Integrationszeit T, wie z. B. einen PLL-Regler, der zwischen Nachverarbeitungsstufe 218 und dem integrierenden Analog-Digital-Umsetzer 210 gekoppelt ist.

Wie im vorherigen Ausführungsbeispiel ist der integrierende Analog-Digital-Umsetzer 210 dazu ausgebildet, auf Basis eines analogen Eingangssignals, z. B. eines Sinussignals, ein digitales Ausgangssignal auszugeben. Dieses wird dann der Nachverarbeitungsstufe 218 in digitaler Form zugeführt. Da die Integrationszeit T des integrierenden Analog-Digital-Umsetzers 210 durch die Steuerung 220 angepasst wird, d. h. verlängert oder verkürzt wird, ändert sich das Übertragungsverhältnis (Gain) des Umsetzers 210. Hintergrund hierzu ist, dass das Übertragungsverhältnis proportional zu der Anzahl der Systemtakte bzw. Samples pro Messintervall ist. Umgekehrt betrachtet heißt das, da die Integrationszeit T bzw. die effektive Messzeit angepasst wird, auch die erfasste Anzahl an Systemtakten variiert, da ja der Systemtakt an sich konstant bleibt. Die Berücksichtigung dieses veränderten Übertragungsverhältnisses erfolgt mittels der Nachverarbeitungsstufe 218, die beispielsweis eine Division der Messergebnisse durch die effektive Messdauer bzw. durch die Anzahl der erfassten Systemtakte durchführt. Deshalb ist neben dem integrierenden Analog-Digital-Umsetzer 210 auch die Nachverarbeitungsstufe 218 mit der Steuerung 220 gekoppelt, um die Information über die angepasste Integrationszeit T zu erhalten. Die Nachverarbeitungseinrichtung 218 skaliert entsprechend das digitale Messergebnis und gibt das skalierte Ergebnis in digitaler Form zur weiteren Verarbeitung an den Signalverarbeiter 250 weiter.

In diesem Ausführungsbeispiel wird dieses von dem digitalen Nachverarbeiter 218 skalierte Ergebnis durch den Analysator 222 der Steuerung 220 analysiert. Der Analysator 222 ist ausgebildet, um den Datenstrom hinsichtlich Phasenfehler $\delta\varphi$ zu untersuchen. Bei sinusförmigen oder periodischen Signalen wird beispielsweise jeder n-te Messwert genommen und verglichen. Abhängig von diesem Phasenfehlersignal $\delta\varphi$ erfolgt dann die Anpassung der Integrationszeit T mittels des Integrationszeitreglers 224 zur Anpassung der Integrationszeit T. Der Integrationszeitregler 224 kann beispielsweise als PLL-Regler (phase-locked-loop, Phasenregelschleife) realisiert sein und ist ausgebildet, um die Integrationszeit T des Integrators (nicht dargestellt) des integrierenden Analog-Digital-Umsetzers 210 zu bestimmen bzw. anzupassen. Das die Integrationszeit T bestimmende Steuersignal wird dem Divisionsbildungselement 218 durch das Schaltungselements 224 zur Verfügung gestellt.

Fig. 3 zeigt ein weiteres Ausführungsbeispiel einer elektrischen Schaltung 300, die eine Signalverarbeitungskette 310 mit einem Analog-Digital-Umsetzer 310a bzw. mit einem Sigma-Delta-Modulator 310a einem Dezimationsfilter 310b umfasst. Die Signalverarbeitungskette 310 ist mit einer Nachverarbeitungsstufe 318, die wiederum ein Divisionsbildungselement umfasst, gekoppelt, über welches das Signal zur Signalverarbeitungsstufe 350 weitergeleitet wird. Wie bei obigen Ausführungsbeispielen wird auch der Ausgangswert des Dezimationsfilters 310b in Abhängigkeit von der gewählten Integrationszeit T bzw. in Abhängigkeit von der Anzahl der Taktzyklen durch die Nachverarbeitungsstufe 318 korrigiert. Die Korrektur basiert im Detail darauf, dass mathematisch der Ausgangswert des Dezimationsfilters 310b dem Integral über dem Eingangssignal des Modulators 310a über die Integrationszeit $T_i$ entspricht. Hieraus folgt:

$$\text{Ausgangswert}\,(t_N) = \int_{t_N}^{t_N + T_i} U\ dt$$

Da ja nun das Ergebnis sowohl proportional zum Betrag des Signals im Integrationszeitraum T ist, als auch zu der Dauer des Integrationszeitraums, kann die Amplitude des Ausgangswerts entsprechend korrigiert werden. Dies geschieht, wie bereits oben erläutert, durch Division bzw. Skalierung mittels des Divisionsbildungselements in der Nachverarbeitungsstufe 318. Bezug nehmend auf das Verhältnis zwischen Integrationsdauer T und Anzahl der Systemtakte sei angemerkt, dass das System typischerweise mit der Anzahl von Systemtakten arbeitet, welche allerdings exakt der jeweiligen Dezimationslänge des aktuellen Messwerts entspricht.

Entsprechend dem Ausführungsbeispiel aus Fig. 2 umfasst die elektrische Schaltung 300 eine Steuerung 320 mit dem Signalanalysator 322 und dem Integrationszeitregler 324. In diesem Ausführungsbeispiel erfolgt die Integration nicht in dem Analog-Digital-Umsetzer 310a, sondern mittels des Dezimationsfilters 310b. Folglich ist der Integrator (Integrator 1. Ordnung mit Reset vor jedem neuen Messwert) Bestandteil des Dezimationsfilters 310b. Deshalb ist in diesem Ausführungsbeispiel die Steuerung 320 mit dem Integrationsfilter 310b (und dem Divisionsbildungselement 318) informatorisch gekoppelt ist, sodass die Steuerung 320 mittels des Integrationszeitreglers 324 das Steuersignal zur Steuerung der Integrationszeit T an diesen ausgeben kann.

Also wird bei diesem inkrementellen Delta-Sigma-Modulator 310a, der mit einem nachgeschalteten Akkumulator bzw. einem digitalen Integrator 310b verwendet wird, die Integrationszeit T bzw. die Anzahl der Taktzyklen, also die Dezimationslänge, über die der Bitstrom am Ausgang des Modulators 310a akkumuliert wird, durch die Steuerung 320 bzw. insbesondere durch den Integrationszeitreglers 324 definiert. Hierzu wird entsprechend Ausführungsbeispielen ein so genannter PLL-Regelungs-Algorithmus benutzt.

Auch wenn bei obigen Ausführungsbeispielen der Sigma-Delta-Wandler als Sigma-Delta-Wandler 1. Ordnung erläutert wurde, wird darauf hingewiesen, dass das beschriebene Verfahren auch bei Sigma-Delta-Modulatoren höherer Ordnung Anwendung (n = 2, 3, ..) finden kann. Das gleiche gilt für die Dezimationsfilter, die bei obiger Ausführung als Dezimationsfilter 1. Ordnung beschrieben wurden. Bei Sigma-Delta-Modulatoren höherer Ordnung bzw. bei Dezimationsfiltern höherer Ordnung hängt die Korrektur der Messwerte ebenfalls von der Dezimationslänge ab. Der Korrekturfaktor wird dann als Funktion der Dezimationslänge und der Struktur des Sigma-Delta-Modulators bzw. des Dezimationsfilters berechnet.

Bezugnehmend auf Fig. 1 sei angemerkt, dass der Delta-Sigma-Modulator 110 (1. Ordnung) eine (4-Bit-) Rückführung aufweisen kann, sodass dieser in einem inkrementellen Modus, d. h. mit Reset nach jeder Umsetzung, betreibbar ist. Hierbei wird typischerweise jede Umsetzung mit einem mit 0 besetzten Dezimationsfilter begonnen. Der ganze Vorgang wird mit jedem Systemtakt neu begonnen, sodass mit jedem Systemtakt das 4-Bit-Ausgangs-Wort des Modulators 110 aufsummiert wird, bis die Integrationszeit T abgelaufen ist.

Entsprechend alternativen Ausführungsbeispielen ist das oben beschriebene Verfahren auch für weitere elektrische Schaltungen einsetzbar, bei denen mittels Signalintegration die effektive Messdauer einstellbar ist. Beispiele hierfür sind Analog-Digital-Umsetzer, wie z.B. Slope-Wandler, Dual-Slope-Wandler oder Multi-Slope-Wandler. Des Weiteren ist die Anwendung dieses Prinzips auch bei anderen integrierenden Wandlern, wie zum Beispiel Digital-Digital-Wandlern (auf Sigma-Delta-Basis) oder Digital-Analog-Wandlern (auf Sigma-Delta-Basis) denkbar.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1.   Elektrische Schaltung (100, 200, 300), mit folgenden Merkmalen:

einer Signalverarbeitungskette (110, 210, 310), die einen Integrator (112) umfasst, der ausgebildet ist, um ein Eingangssignal mit einer Grundwelle über eine Integrationszeit (T) hinweg zu integrieren;
wobei die elektrische Schaltung (100, 200, 300) folgenden weitere Merkmale aufweist:
eine Steuerung (120, 220, 320), die mit einem Signalausgang (110a) der Signalverarbeitungskette (110, 210, 310) verbunden ist, um ein Ausgangssignal der Signalverarbeitungskette (110, 210, 310) zu empfangen und auszuwerten, und die ausgebildet ist, um die Integrationszeit (T) basierend auf dem Ausgangssignal anzupassen; **dadurch gekennzeichnet, dass** die Steuerung (120, 220, 320) die Integrationszeit (T) anpasst, um unter Berücksichtigung eines Teilungsfaktors zwischen einem Systemtakt der elektrischen Schaltung (100, 200, 300) und der Periode einer Grundwelle des Eingangssignals eine Synchronisation von mindestens 90% zwischen der Integrationszeit (T) und der Periode zu erreichen.

2.   Elektrische Schaltung (100, 200, 300) gemäß Anspruch 1, wobei die Steuerung (120, 220, 320) die Integrationszeit (T) so anpasst, dass eine Periode der Grundwelle des Eingangssignals ein ganzzahliges Vielfaches der mittleren Integrationszeit (T) ist.

3.   Elektrische Schaltung (100, 200, 300) gemäß einem der Ansprüche 1 bis 2, wobei die Signalverarbeitungskette (110, 210, 310) einen Sigma-Delta-Modulator (110, 210, 310a) umfasst.

4.   Elektrische Schaltung (100, 200, 300) gemäß Anspruch 3, wobei der Sigma-Delta-Modulator (110, 210, 310a) n-ter Ordnung mit n ≥ 1 ist.

5.   Elektrische Schaltung (100, 200, 300) gemäß einem der Ansprüche 1 bis 4, wobei die Signalverarbeitungskette (110, 210, 310) einen mit dem Integrator (112) gekoppelten Komparator (114) umfasst.

6.   Elektrische Schaltung (100, 200, 300) gemäß einem der Ansprüche 1 bis 5, wobei die Signalverarbeitungskette (110, 210, 310) einen Filter und/oder DezimationsFilter (310b) umfasst, der den Integrator (112) aufweist.

7.   Elektrische Schaltung (100, 200, 300) gemäß einem der Ansprüche 1 bis 6, wobei die Schaltung mit einem Oszillator verbunden ist oder den Oszillator umfasst, der ein Oszillationssignal mit konstanter Frequenz an die Signalverarbeitungskette (110, 210, 310) ausgibt.

8.   Elektrische Schaltung (100, 200, 300) gemäß einem der Ansprüche 1 bis 7, wobei das Integral des Ausgangssignals über die Integrationszeit (T) proportional zu der Integrationszeit (T) ist.

9.   Elektrische Schaltung (100, 200, 300) gemäß Anspruch 8, wobei die Signalverarbeitungskette (110, 210, 310) mit einer Nachverarbeitungsstufe (218, 318) gekoppelt ist, die ein Divisionsbildungselement (218, 318) umfasst, das ausgebildet ist, um das Ausgangssignal der Signalverarbeitungskette (110, 210, 310) durch die Integrationszeit (T) zu dividieren und einen Divisionswert als Ergebnis auszugeben.

10.  Elektrische Schaltung (100, 200, 300) gemäß Anspruch 9, wobei die Steuerung (120, 220, 320) mit der Nachverarbeitungsstufe (218, 318) gekoppelt ist.

11.  Elektrische Schaltung (100, 200, 300) gemäß einem der Ansprüche 1 bis 10, wobei die Steuerung (120, 220, 320) einen Phasen-Diskriminator (222, 322) umfasst, der ausgebildet ist, um das Ausgangssignal hinsichtlich Phasenfehler auszuwerten, und wobei die Steuerung (120, 220, 320) die Integrationszeit (T) derart anpasst, dass die Phasenfehler minimiert werden.

12.  Elektrische Schaltung (100, 200, 300) gemäß einem der Ansprüche 1 bis 11, wobei der Integrator (112) durch ein von der Steuerung (120, 220, 320) ausgegebenes Steuersignal zurückgesetzt wird, sodass der Integrator (112) einen neuen Messwert ohne Einfluss vergangener Messwerte bildet.

13. Elektrische Schaltung (100, 200, 300) gemäß einem der Ansprüche 1 bis 12, wobei die Steuerung (120, 220, 320) eine Phasenregelschleife (224, 324) umfasst, die ein Steuersignal ausgibt, mittels welchem die Integrationszeit (T) des Integrators (112) gesteuert wird.

14. Elektrische Schaltung (100, 200, 300) gemäß einem der Ansprüche 1 bis 13, wobei die Signalverarbeitungskette (110, 210, 310) ausgebildet ist, um auf Basis eines analogen Eingangssignals ein digitales Ausgangssignal bereitzustellen.

15. Verfahren (1000) zur Signalverarbeitung, mit folgenden Schritten:

Integrieren eines Eingangssignals (1100) über eine Integrationszeit (T) hinweg mittels einer Signalverarbeitungskette (110, 210, 310) einer elektrischen Schaltung gemäß Anspruch 1, die einen Integrator (112) umfasst;
wobei das Verfahren folgende weitere Schritte aufweist:

Empfangen und Auswerten eines Ausgangssignals (1200) der Signalverarbeitungskette (110, 210, 310); und
Anpassen der Integrationszeit (T) (1300) basierend auf dem Ausgangssignal,

dadurch gekennzeichnet, dass Synchronisieren die Periode einer Grundwelle des Eingangssignals mit der Integrationszeit (T), unter Berücksichtigung einer Teilungsfaktors zwischen einem Systemtakt der elektrischen Schaltung und der Periode einer Grundwelle des Eingangssignals, sodass eine Synchronisation von mindestens 90% erreicht.

16. Computerprogramm mit einem Programmcode zur Durchführung des Verfahrens nach Anspruch 15, wenn das Programm auf einem Computer abläuft.

**Claims**

1. Electrical circuit (100, 200, 300), comprising:

a signal processing chain (110, 210, 310) including an integrator (112) configured to integrate an input signal with a fundamental wave over an integration time (T);

said electrical circuit (100, 200, 300) further comprising:

a controller (120, 220, 320) connected to a signal output (110a) of the signal processing chain (110, 210, 310) to receive and evaluate an output signal of the signal processing chain (110, 210, 310), and configured to adapt the integration time (T) based on the output signal;
**characterized in that** the controller (120, 220, 320) adapts the integration time (T) to achieve a synchronization of at least 90% between the integration time (T) and the period, taking into account a division factor between a system clock of the electrical circuit (100, 200, 300) and the period of a fundamental wave of the input signal.

2. Electrical circuit (100, 200, 300) according to claim 1, wherein the controller (120, 220, 320) adapts the integration time (T) such that a period of the fundamental wave of the input signal is an integer multiple of the average integration time (T).

3. Electrical circuit (100, 200, 300) according to any one of claims 1 to 2, wherein the signal processing chain (110, 210, 310) includes a sigma-delta modulator (110, 210, 310a).

4. Electrical circuit (100, 200, 300) according to claim 3, wherein the sigma-delta modulator (110, 210, 310a) is of $n^{th}$ order with $n \geq 1$.

5. Electrical circuit (100, 200, 300) according to any one of claims 1 to 4, wherein the signal processing chain (110, 210, 310) includes a comparator (114) coupled to the integrator (112).

6. Electrical circuit (100, 200, 300) according to any one of claims 1 to 5, wherein the signal processing chain (110, 210, 310) comprises a filter and/or decimation filter (310b) which comprises the integrator (112).

7. Electrical circuit (100, 200, 300) according to any one of claims 1 to 6, wherein the circuit is connected to an oscillator or includes the oscillator which outputs an oscillation signal of constant frequency to the signal processing chain (110, 210, 310).

8. Electrical circuit (100, 200, 300) according to any one of claims 1 to 7, wherein the integral of the output signal over the integration time (T) is proportional to the integration time (T).

9. Electrical circuit (100, 200, 300) according to claim 8, wherein the signal processing chain (110, 210, 310) is coupled to a post-processing stage (218, 318) including a division formation element (218, 318) which is configured to divide the output signal of the signal processing chain (110, 210, 310) by the integration time (T) and to output a division value as a result.

10. Electrical circuit (100, 200, 300) according to claim 9, wherein the controller (120, 220, 320) is coupled to the post-processing stage (218, 318).

11. Electrical circuit (100, 200, 300) according to any one of claims 1 to 10, wherein the controller (120, 220, 320) includes a phase discriminator (222, 322) which is configured to evaluate the output signal regarding phase errors, and wherein the controller (120, 220, 320) adapts the integration time (T) such that the phase errors are minimized.

12. Electrical circuit (100, 200, 300) according to any one of claims 1 to 11, wherein the integrator (112) is reset by a control signal output by the controller (120, 220, 320) so that the integrator (112) forms a new measurement value without any impact from past measurement values.

13. Electrical circuit (100, 200, 300) according to any one of claims 1 to 12, wherein the controller (120, 220, 320) includes a phase-locked loop (224, 324) which outputs a control signal by which the integration time (T) of the integrator (112) is controlled.

14. Electrical circuit (100, 200, 300) according to any one of claims 1 to 13, wherein the signal processing chain (110, 210, 310) is configured to provide a digital output signal based on an analog input signal.

15. Method (1000) for signal processing, comprising:

integrating an input signal (1100) over an integration time (T) by means of a signal processing chain (110, 210, 310) of an electrical circuit according to claim 1 including an integrator (112); the method further comprising:

receiving and evaluating an output signal (1200) of the signal processing chain (110, 210, 310); and adapting the integration time (T) (1300) based on the output signal,

**characterized in that** synchronizing the period of a fundamental wave of the input signal with the integration time (T), taking into account a division factor between a system clock of the electrical circuit and the period of a fundamental wave of the input signal, achieves a synchronization of at least 90%.

16. Computer program with a program code for performing the method according to claim 15 when the program runs on a computer.

**Revendications**

1. Circuit électrique (100, 200, 300), aux caractéristiques suivantes:

une chaîne de traitement de signal (110, 210, 310) comportant un intégrateur (112) qui est conçu pour intégrer un signal d'entrée avec une onde fondamentale sur une durée d'intégration (T); dans lequel le circuit électrique (100, 200, 300) présente les caractéristiques additionnelles suivantes:

un moyen de commande (120, 220, 320) connecté à une sortie de signal (110a) de la chaîne de traitement de signal (110, 210, 310) destiné à recevoir et évaluer un signal de sortie de la chaîne de traitement de signal (110, 210, 310) et conçu pour adapter la durée d'intégration (T) sur base du signal de sortie; **caractérisé par le fait que** le moyen de commande (120, 220, 320) adapte la durée d'intégration (T) pour obtenir, en tenant compte d'un facteur de division entre une horloge de système du circuit électrique (100, 200, 300) et la période d'une onde fondamentale du signal d'entrée, une synchronisation d'au moins 90% entre la durée d'intégration (T) et la période.

2. Circuit électrique (100, 200, 300) selon la revendication 1, dans lequel le moyen de commande (120, 220, 320) adapte la durée d'intégration (T) de sorte qu'une période de l'onde fondamentale du signal d'entrée soit un multiple entier de la durée d'intégration moyenne (T).

3. Circuit électrique (100, 200, 300) selon l'une des revendications 1 à 2, dans lequel la chaîne de traitement de signal (110, 210, 310) comporte un modulateur sigma-delta (110, 210, 310a).

4. Circuit électrique (100, 200, 300) selon la revendication 3, dans lequel le modulateur sigma-delta (110, 210, 310a) est de l'ordre n, où $n \geq 1$.

5. Circuit électrique (100, 200, 300) selon l'une des revendications 1 à 4, dans lequel la chaîne de traitement de signal (110, 210, 310) comporte un comparateur (114) couplé à l'intégrateur (112).

**6.** Circuit électrique (100, 200, 300) selon l'une des revendications 1 à 5, dans lequel la chaîne de traitement de signal (110, 210, 310) comporte un filtre et/ou un filtre de décimation (310b) qui présente l'intégrateur (112).

**7.** Circuit électrique (100, 200, 300) selon l'une des revendications 1 à 6, dans lequel le circuit est connecté à un oscillateur ou comporte l'oscillateur qui sort un signal d'oscillation à fréquence constante vers la chaîne de traitement de signal (110, 210, 310).

**8.** Circuit électrique (100, 200, 300) selon l'une des revendications 1 à 7, dans lequel l'intégrale du signal de sortie sur la durée d'intégration (T) est proportionnelle à la durée d'intégration (T).

**9.** Circuit électrique (100, 200, 300) selon la revendication 8, dans lequel la chaîne de traitement de signal (110, 210, 310) est couplée à un étage de post-traitement (218, 318) comportant un élément de formation de division (218, 318) qui est conçu pour diviser le signal de sortie de la chaîne de traitement de signal (110, 210, 310) par la durée d'intégration (T) et pour sortir une valeur de division comme résultat.

**10.** Circuit électrique (100, 200, 300) selon la revendication 9, dans lequel le moyen de commande (120, 220, 320) est couplé à l'étage de post-traitement (218, 318).

**11.** Circuit électrique (100, 200, 300) selon l'une des revendications 1 à 10, dans lequel le moyen de commande (120, 220, 320) comporte un discriminateur de phase (222, 322) qui est conçu pour évaluer le signal de sortie quant à des erreurs de phase, et dans lequel le moyen de commande (120, 220, 320) adapte la durée d'intégration (T) de sorte que les erreurs de phase soient minimisées.

**12.** Circuit électrique (100, 200, 300) selon l'une des revendications 1 à 11, dans lequel l'intégrateur (112) est réinitialisé par un signal de commande sorti par le moyen de commande (120, 220, 320), de sorte que l'intégrateur (112) forme une nouvelle valeur de mesure sans influence de valeurs de mesure passées.

**13.** Circuit électrique (100, 200, 300) selon l'une des revendications 1 à 12, dans lequel le moyen de commande (120, 220, 320) comporte une boucle de réglage de phase (224, 324) qui sort un signal de commande au moyen duquel est régulée la durée d'intégration (T) de l'intégrateur (112).

**14.** Circuit électrique (100, 200, 300) selon l'une des revendications 1 à 13, dans lequel la chaîne de traitement de signal (110, 210, 310) est conçue pour fournir, sur base d'un signal d'entrée analogique, un signal de sortie numérique.

**15.** Procédé (1000) de traitement du signal, aux étapes suivantes consistant à:

intégrer un signal d'entrée (1100) sur une durée d'intégration (T) au moyen d'une chaîne de traitement de signal (110, 210, 310) d'un circuit électrique selon la revendication 1 qui comporte un intégrateur (112);
dans lequel le procédé comporte les étapes additionnelles suivantes consistant à:

recevoir et évaluer un signal de sortie (1200) de la chaîne de traitement de signal (110,210,310); et
adapter la durée d'intégration (T) (1300) sur base du signal de sortie,

**caractérisé par le fait que** la synchronisation de la période d'une onde fondamentale du signal d'entrée avec la durée d'intégration (T), en tenant compte d'un facteur de division entre une horloge de système du circuit électrique et la période d'une onde fondamentale du signal d'entrée, atteint une synchronisation d'au moins 90%.

**16.** Programme d'ordinateur avec un code de programme pour la mise en oeuvre du procédé selon la revendication 15 lorsque le programme est exécuté sur un ordinateur.

EP 3 069 448 B1

FIGUR 1A

1000

1100

1200

1300

FIGUR 1B

FIGUR 2

FIGUR 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2012003909

- US 2007247340 A1